# FASCICULE DE BREVET EUROPEEN

(11) **EP 3 156 810 B1**
(45) Date de publication et mention de la délivrance du brevet: **18.12.2019**
(21) Numéro de dépôt: 16193970.7
(22) Date de dépôt: 14.10.2016
(51) Int. Cl.: G01R 29/08

(54) **MESURE D'ATTENUATION DE BLINDAGE**
MESSUNG DER ABSCHWÄCHUNG EINER ABSCHIRMUNG
MEASUREMENT OF SHIELDING ATTENUATION

(30) Priorité: 16.10.2015 FR 1559888
(43) Date de publication de la demande: 19.04.2017
(73) Titulaire: COMMISSARIAT À L'ÉNERGIE ATOMIQUE ET AUX ÉNERGIES ALTERNATIVES, 75015 Paris (FR)
(72) Inventeur: JOLY, Jean-Christophe, 46500 GRAMAT (FR); JONNIAU, Sylvain, 59262 SAINGHIN EN MELANTOIS (FR); WERQUIN, Matthieu, 59262 SAINGHIN EN MELANTOIS (FR); VELLAS, Nicolas, 59262 SAINGHIN EN MELANTOIS (FR); GAQUIÈRE, Christophe, 59262 SAINGHIN EN MELANTOIS (FR); CHOTEAU, Benjamin, 59262 SAINGHIN EN MELANTOIS (FR)
(74) Mandataire: Brevalex

(56) Documents cités:
- US-B1- 6 255 830
- PERKIN ELMER: "What is a Lock-in Amplifier?", TECHNICAL NOTE PERKINELMER, 1 avril 2000 (2000-04-01), pages 1-4, XP002416964,
- HATFIELD M O: "Shielding effectiveness measurements using mode-stirred chambers: a comparison of two approaches", IEEE TRANSACTIONS ON ELECTROMAGNETIC COMPATIBILITY, vol. 30, no. 3, août 1988 (1988-08), pages 229-238, XP002759949, USA ISSN: 0018-9375, DOI: 10.1109/15.3301

## Description

### DOMAINE TECHNIQUE

La présente invention concerne la mesure d'atténuation de blindage électromagnétique d'une infrastructure, en fonction de la fréquence.

### ÉTAT DE LA TECHNIQUE ANTÉRIEURE

L'atténuation de blindage électromagnétique d'une infrastructure, dite aussi efficacité de blindage ou encore faradisation, est classiquement mesurée selon le principe d'une double pesée. Pour cela, un dispositif de mesure comportant un émetteur et un récepteur de signal est utilisé de la manière suivante.

Une première mesure de référence ou de calibration est effectuée avec l'émetteur et le récepteur disposés en l'absence d'infrastructure à une distance prédéterminée. L'émetteur émet un signal d'une puissance d'émission donnée et ce signal est reçu par le récepteur.

Une seconde mesure est effectuée en disposant au préalable l'émetteur et le récepteur de part et d'autre de l'infrastructure dont on veut déterminer l'atténuation de blindage. L'émetteur et le récepteur sont disposés à la même distance et selon la même orientation et le signal est émis avec la même puissance d'émission que pour la première mesure. Ce signal est reçu par le récepteur.

L'atténuation de blindage est le rapport de la première puissance reçue sur la seconde.

La mesure d'atténuation est effectuée en fonction de la fréquence, typiquement de l'ordre du kHz à la dizaine de GHz. L'atténuation de blindage est donc donnée en fonction de la fréquence : par exemple, un facteur 5 en puissance (soit 10log₁₀5=7 dB) à 1 GHz. Cela implique une synchronisation de fréquence entre émission et réception.

Une première solution pour synchroniser émetteur et récepteur est de faire les mesures à des fréquences discrètes. Dans ce cas, une mesure n'est valable qu'à une fréquence donnée et il faut reproduire les étapes de mesure pour chaque fréquence.

Une deuxième solution pour synchroniser est d'établir une liaison entre émetteur et récepteur. Cette liaison peut être établie via un conducteur filaire ou une fibre optique, mais cela impose la présence d'une voie de passage, telle que par exemple une ouverture, une structure en nid d'abeille ou un guide d'onde, à travers l'infrastructure. En outre, le passage d'un conducteur filaire sans reprise de blindage fausserait la mesure, puisque le conducteur filaire serait perçu comme un défaut de faradisation.

La liaison entre émetteur et récepteur peut aussi être réalisée par onde radio, éventuellement dans la bande de mesure. Cela n'est possible que si l'atténuation de blindage de l'infrastructure est relativement limitée, de sorte que l'onde radio puisse transiter à travers l'infrastructure.

Par ailleurs, l'environnement électromagnétique de l'infrastructure à caractériser est susceptible d'être bruité. En effet, des ondes GSM, wifi ou radar, par exemple, peuvent former une pollution électromagnétique ambiante. Cette pollution électromagnétique pourrait être interprétée comme un défaut de faradisation de l'infrastructure. Ainsi, l'atténuation de blindage mesurée serait erronée aux fréquences de la pollution électromagnétique.

Pour prendre en compte la pollution électromagnétique avec les mesureurs connus, il est possible de réaliser une mesure de bruit ambiant préalablement à la calibration. Une puissance de bruit est ainsi déterminée. Elle est soustraite des mesures de puissance effectuées ensuite, lors du calcul d'atténuation.

Cependant, ce calcul suppose que la pollution électromagnétique est constante dans le temps. Si elle est intermittente et si elle varie entre les mesures ou pendant les mesures, l'atténuation calculée est alors faussée.

US 6 255 830 concerne la mesure d'atténuation de blindage électromagnétique d'une infrastructure. Ce document est conforme à la première solution évoquée plus haut, c'est-à-dire que les mesures sont effectuées à des fréquences discrètes.

L'article « What is a lock-in Amplifier » de Perkin Elmer, 1er avril 2000, concerne un amplificateur à verrouillage et ses applications possibles. Ce document ne concerne pas la mesure d'atténuation de blindage.

L'article « Shielding effectiveness measurements using mode-stirred chambers : a comparison of two approaches », IEEE Transactions on Electromagnetic Compatibility, vol. 30, n° 3, août 1988, pages 229-238, concerne la mesure d'efficacité de blindage et compare deux méthodes : l'une est la méthode à fréquence discrète et l'autre est dite « méthode bruitée » qui utilise des sources de bruit large bande. Dans les deux cas, une chambre à brassage de mode est utilisée.

### EXPOSÉ DE L'INVENTION

L'invention vise à résoudre les problèmes de la technique antérieure en fournissant un récepteur pour un système de mesure d'atténuation de blindage électromagnétique d'une infrastructure, en fonction de la fréquence,
caractérisé en ce qu'il est apte à recevoir un signal émis par un émetteur d'un signal qui est un bruit blanc de puissance constante sur une bande de fréquence comprise entre une fréquence minimale et une fréquence maximale, l'émetteur et le récepteur étant aptes à émettre et recevoir un signal de part et d'autre de l'infrastructure,
Et caractérisé en ce qu'il comporte
Un module de filtrage apte à réaliser un filtrage glissant sur le signal reçu (SR) entre la fréquence minimale et la fréquence maximale, et
Un module de double détection synchrone apte à réaliser une double détection synchrone sur un signal fourni par le module de filtrage, et
Un module de détermination de l'atténuation de blindage en fonction des résultats fournis par le module de double détection synchrone déterminés suite à l'émission et la réception de signal réalisées en l'absence de l'infrastructure puis de part et d'autre de l'infrastructure.

Grâce à l'invention, la mesure d'atténuation de blindage est effectuée de manière plus simple et plus rapide que selon la technique antérieure.

En particulier, la mesure est effectuée pour une fréquence choisie dans une gamme de fréquence, sans qu'il soit nécessaire de répéter les opérations d'émission et de réception de signal.

L'invention concerne aussi un système de mesure d'atténuation de blindage électromagnétique d'une infrastructure, en fonction de la fréquence, caractérisé en ce qu'il comporte :
Un émetteur d'un signal qui est un bruit blanc de puissance constante sur une bande de fréquence comprise entre une fréquence minimale et une fréquence maximale,
Un récepteur de signal tel que précédemment présenté.

Selon une caractéristique préférée :
L'émetteur est apte à émettre un signal qui est un bruit blanc haché comportant deux niveaux de puissance alternatifs, et
Le récepteur est apte à déterminer la différence entre les puissances reçues correspondant aux deux niveaux de puissance du signal émis.

Ainsi la contribution du bruit ambiant peut être annulée. La mesure d'atténuation de blindage selon la présente invention est indépendante de l'environnement électromagnétique.

L'invention concerne aussi un procédé de mesure d'atténuation de blindage électromagnétique d'une infrastructure, en fonction de la fréquence, caractérisé en ce qu'il comporte les étapes de :
Emission d'un signal qui est un bruit blanc de puissance constante sur une bande de fréquence comprise entre une fréquence minimale et une fréquence maximale,
Réception d'un signal, l'émission et la réception de signal étant effectuée de part et d'autre de l'infrastructure,
Filtrage glissant sur le signal reçu entre la fréquence minimale et la fréquence maximale,
Double détection synchrone sur un signal fourni par le module de filtrage et en ce qu'il comporte en outre des étapes préalables d'émission et de réception de signal en l'absence de l'infrastructure, de filtrage glissant sur le signal reçu et de double détection synchrone sur un signal fourni par le module de filtrage et une étape de détermination de l'atténuation de blindage en fonction des résultats des étapes de filtrage glissant et de double détection synchrone effectuées suite à l'émission et la réception de signal en l'absence de l'infrastructure puis de part et d'autre de l'infrastructure.

Le système et le procédé présentent des avantages analogues à ceux précédemment présentés.

Dans un mode particulier de réalisation, les étapes de filtrage glissant et double détection synchrone du procédé selon l'invention sont mises en oeuvre par des instructions de programme d'ordinateur.

En conséquence, l'invention vise aussi un programme d'ordinateur sur un support d'informations, ce programme étant susceptible d'être mis en œuvre dans un ordinateur, ce programme comportant des instructions adaptées à la mise en œuvre des étapes de filtrage glissant et double détection synchrone d'un procédé tel que décrit ci-dessus.

Ce programme peut utiliser n'importe quel langage de programmation, et être sous la forme de code source, code objet, ou de code intermédiaire entre code source et code objet, tel que dans une forme partiellement compilée, ou dans n'importe quelle autre forme souhaitable.

L'invention vise aussi un support d'informations lisible par un ordinateur, et comportant des instructions de programme d'ordinateur adaptées à la mise en œuvre des étapes d'un procédé tel que décrit ci-dessus.

Le support d'informations peut être n'importe quelle entité ou dispositif capable de stocker le programme. Par exemple, le support peut comporter un moyen de stockage, tel qu'une ROM, par exemple un CD ROM ou une ROM de circuit microélectronique, ou encore un moyen d'enregistrement magnétique, par exemple une disquette ou un disque dur.

D'autre part, le support d'informations peut être un support transmissible tel qu'un signal électrique ou optique, qui peut être acheminé via un câble électrique ou optique, par radio ou par d'autres moyens. Le programme selon l'invention peut être en particulier téléchargé sur un réseau de type Internet.

Alternativement, le support d'informations peut être un circuit intégré dans lequel le programme est incorporé, le circuit étant adapté pour exécuter ou pour être utilisé dans l'exécution du procédé selon l'invention.

### BRÈVE DESCRIPTION DES DESSINS

D'autres caractéristiques et avantages apparaîtront à la lecture de la description suivante d'un mode de réalisation préféré, donné à titre d'exemple non limitatif, décrit en référence aux figures dans lesquelles :
La figure 1 représente un système de mesure d'atténuation de blindage, selon un mode de réalisation de la présente invention,
La figure 2 représente un procédé de mesure d'atténuation de blindage, selon un mode de réalisation de la présente invention,
La figure 3 représente un signal émis par le système de mesure d'atténuation de blindage, selon un mode de réalisation de la présente invention,
La figure 4 représente un filtrage glissant réalisé sur un signal reçu, par le système de mesure d'atténuation de blindage, selon un mode de réalisation de la présente invention,
La figure 5 représente un signal émis par le système de mesure d'atténuation de blindage, selon un mode de réalisation de la présente invention,
Les figures 6a et 6b représentent respectivement un signal reçu par le système de mesure d'atténuation de blindage, selon un mode de réalisation de la présente invention.

### EXPOSÉ DÉTAILLÉ DE MODES DE RÉALISATION PARTICULIERS

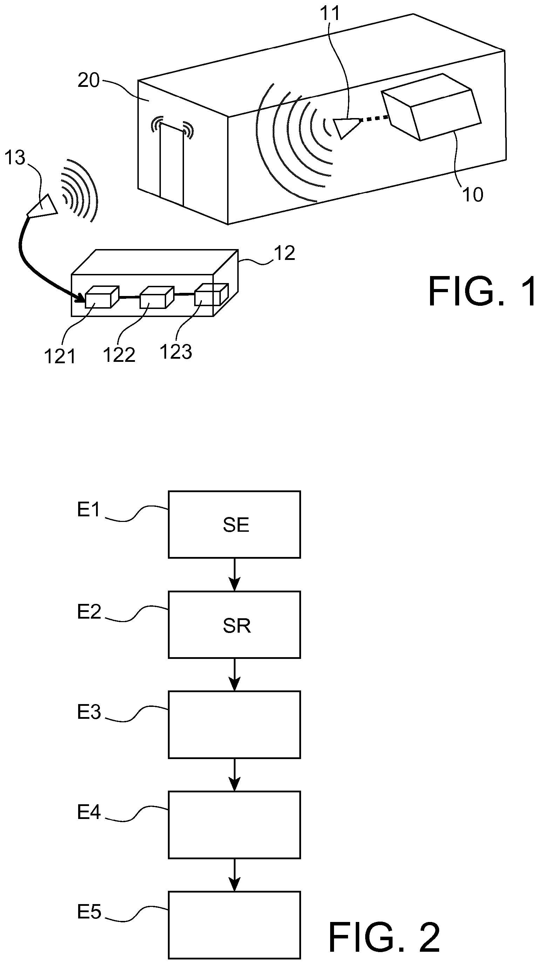

Selon un mode de réalisation préféré et représenté à la **figure 1****,** un système de mesure d'atténuation de blindage comporte un émetteur de signal 10 relié à une antenne d'émission 11. L'émetteur 10 est apte à émettre un signal qui est décrit dans la suite.

Le système de mesure d'atténuation de blindage comporte également un récepteur 12 relié à une antenne de réception 13.

Les antennes d'émission et de réception peuvent être de tout type, par exemple :
- Directionnelles ou omnidirectionnelles,
- Large bande ou bande étroite,
- A polarisation rectiligne ou circulaire,
- A dépointage électronique ou mécanique,
- Filaires, à ouverture ou planaires, à ondes progressives ou stationnaires.

Le récepteur 12 est apte à recevoir un signal reçu par l'antenne de réception 13. Le récepteur 12 comporte un module de filtrage 121, un module de double détection synchrone 122 et un module de traitement des mesures 123 pour déterminer l'atténuation d'un blindage. Les traitements réalisés par les différents modules sont décrits dans la suite.

Le système de mesure d'atténuation de blindage peut être alimenté par batterie.

Il est à noter que seuls les éléments du système de mesure d'atténuation de blindage qui sont utiles à la compréhension de l'invention sont décrits.

Le système de mesure d'atténuation de blindage est utilisé selon le principe de double pesée. Une première mesure, dite mesure de référence, est effectuée lorsque l'antenne d'émission 11 et l'antenne de réception 13 sont disposées en l'absence de la structure dont on souhaite déterminer l'atténuation de blindage, à une distance et selon une orientation déterminées. L'antenne d'émission et l'antenne de réception sont ensuite placées de part et d'autre de la structure dont on souhaite déterminer l'atténuation de blindage, à la même distance et selon la même orientation déterminées. Une seconde mesure est effectuée.

Les signaux émis pour les deux mesures sont de même puissance.

L'atténuation de blindage est le rapport des puissances reçues lors des deux opérations de mesure. La mesure d'atténuation est effectuée en fonction de la fréquence, typiquement de l'ordre du kHz à la dizaine de GHz.

La figure 1 illustre la configuration pour effectuer la seconde mesure, dans le cas où la structure est une paroi 20 d'une pièce d'un bâtiment. La paroi 20 comporte une porte 21 dont les angles constituent de potentiels défauts de blindage. Les antennes 11 et 13 sont ainsi placées de part et d'autre de la paroi 20.

La **figure 2** représente le fonctionnement du système de mesure d'atténuation de blindage, selon un mode de réalisation de l'invention. Ce fonctionnement est représenté sous la forme d'un organigramme comportant des étapes E1 à E5.

L'étape E1 est l'émission d'un signal SE par l'émetteur 10.

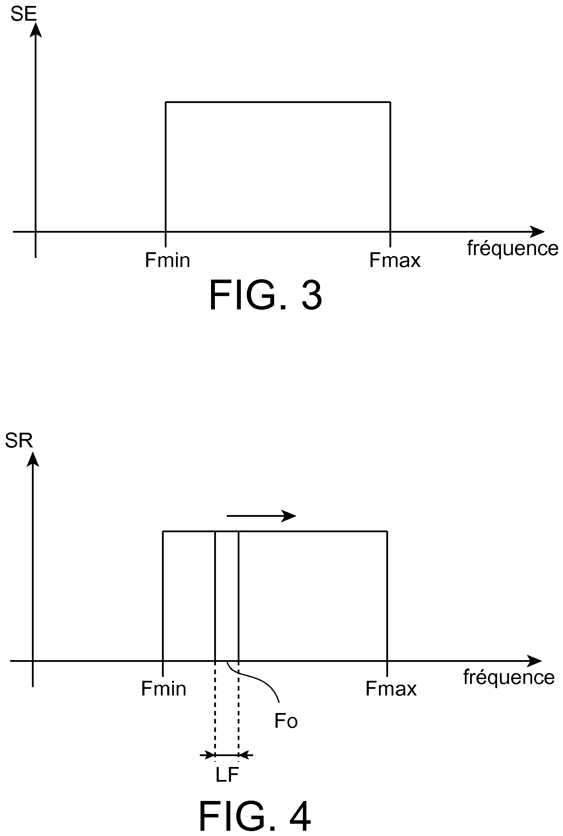

La **figure 3** représente le signal SE émis par l'émetteur 10, en fonction de la fréquence. Le signal émis SE est un bruit blanc de puissance constante, sur une bande de fréquence comprise entre une fréquence minimale Fₘᵢₙ et une fréquence maximale Fₘₐₓ.

L'étape suivante E2 est la réception d'un signal SR par le récepteur 12.

L'étape suivante E3 est un filtrage glissant réalisé sur le signal reçu SR.

La **figure 4** représente le filtrage glissant qui est réalisé sur le signal reçu SR par le récepteur 12. Le signal SR est dans la bande de fréquence comprise entre les fréquences Fₘᵢₙ et Fₘₐₓ.

Un filtre glissant est appliquée entre les fréquences Fₘᵢₙ et Fₘₐₓ. Le filtre glissant a une largeur LF prédéterminée autour d'une fréquence F₀ qui varie de Fₘᵢₙ à Fₘₐₓ.

L'étape suivante E4 est la détermination de la puissance reçue, à une fréquence donnée comprise dans la bande de fréquence du signal d'émission SE. La puissance reçue est exprimée en Watts. Elle est mémorisée dans une mémoire, non représentée, interne au récepteur ou associée à ce dernier.

Comme exposé précédemment, une mesure de référence est effectuée lorsque l'antenne d'émission et l'antenne de réception sont disposées en l'absence de la structure dont on souhaite déterminer l'atténuation de blindage, à une distance et selon une orientation déterminées. Les étapes E1 à E4 sont donc parcourues pour cette première mesure. La puissance mémorisée est alors une puissance reçue de référence PR_{ref}. Il est à noter que cette puissance dépend de la distance entre antenne d'émission et antenne de réception, de l'orientation des antennes et de la puissance du signal émis. A condition que ces paramètres soient respectivement égaux pour différentes déterminations d'atténuation de blindage, une même puissance reçue de référence peut donc être utilisée ultérieurement pour ces différentes déterminations d'atténuation de blindage.

L'antenne d'émission et l'antenne de réception sont ensuite placées de part et d'autre de la structure dont on souhaite déterminer l'atténuation de blindage, à la même distance et selon la même orientation déterminées. Une seconde mesure est effectuée, à partir du même signal d'émission SE. Les étapes E1 à E4 sont donc parcourues pour cette seconde mesure. L'étape E4 a alors pour résultat une puissance de signal reçu PR pour une fréquence donnée comprise dans la bande de fréquence du signal d'émission SE.

L'étape E5 est la détermination de l'atténuation de blindage pour une ou des fréquence(s) de la bande de fréquence comprise entre les fréquences Fₘᵢₙ et Fₘₐₓ.

L'atténuation de blindage est déterminée pour une fréquence donnée F. Elle est égale au rapport de la puissance du signal de référence PR_{ref} et de la puissance du signal reçu PR lors de la deuxième mesure, à la fréquence donnée F. On rappelle que les puissances sont exprimées en Watts. L'étape E5 est détaillée dans la suite.

Les variations éventuelles de bruit d'environnement entre les deux mesures sont prises en compte de la manière suivante.

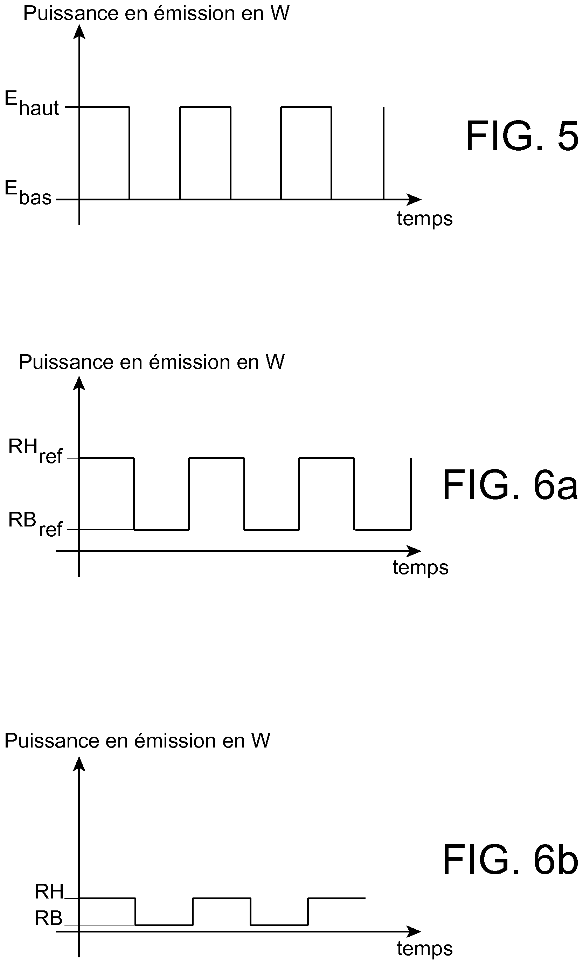

La **figure 5** représente le signal émis SE par l'émetteur 10 en fonction du temps. Le signal émis SE est un bruit blanc haché, en forme de créneaux de rapport cyclique ½. Le rapport cyclique peut être différent.

La puissance émise est alternativement à un état haut Eₕₐᵤₜ correspondant à un temps d'émission et à un état bas E_{bas} où la puissance émise est nulle, correspondant à arrêt d'émission.

Les **figures 6a et 6b** représentent le signal reçu SR par le récepteur 12 en fonction du temps, respectivement lors de la mesure de référence et lors de la seconde mesure.

Dans les deux cas, mesure de référence et seconde mesure, le signal reçu SR est également haché, en forme de créneaux de rapport cyclique ½. La puissance reçue est alternativement à un état haut correspondant à un temps d'émission et à un état bas où la puissance reçue est plus faible mais non nulle, correspondant à arrêt d'émission. La puissance reçue à l'état bas correspond au bruit d'environnement et la puissance reçue à l'état haut correspond à la somme du bruit blanc reçu depuis l'émetteur et du bruit d'environnement.

Après la mesure de référence, la différence entre la puissance reçue à l'état haut RH_{ref} et la puissance reçue à l'état bas RB_{ref} est calculée, ce qui permet d'annuler la contribution du bruit ambiant.

De même, après la seconde mesure, la différence entre la puissance reçue à l'état haut RH et la puissance reçue à l'état bas RB est calculée, toujours pour annuler la contribution du bruit ambiant.

Afin de mesurer la différence de puissance reçue entre les phases successives d'émission et d'arrêt de l'émission sans connaître l'instant du changement de phase commandé par l'émetteur 10, le module 122 met en œuvre une double détection synchrone. Cela permet de s'affranchir d'un éventuel déphasage Δϕ entre le signal reçu SR à la fréquence de modulation Fm et un signal de démodulation.

On considère le traitement effectué sur le signal Vᵢₙ issu du filtre glissant 121. Le signal Vᵢₙ est appliqué en entrée du module de double détection synchrone 122. La quantité ΔVᵢₙ est représentative de la différence des puissances reçues (RH-RB) correspondant à l'émission du bruit blanc de rapport cyclique ½.

Par rapport à une détection synchrone classique, le module 122 effectue une première démodulation à la fréquence de modulation Fm et une seconde démodulation à la fréquence (Fm+π/2). Les quantités : 0,5.ΔVᵢₙ.cos(Δϕ) et 0,5.ΔVᵢₙ.cos(Δϕ+π/2) = 0,5.ΔVᵢₙ.sin(Δϕ) sont ainsi déterminées. Ces quantités sont ensuite élevées au carré puis sommées. Le module 122 fournit alors en sortie la quantité (0,5.ΔVᵢₙ)².(cos²(Δϕ) + sin²(Δϕ)). Cette quantité est égale à (0,5.ΔVᵢₙ)².

Ainsi on obtient un signal de sortie égal à (0,5.ΔVᵢₙ)². Le signal de sortie est indépendant d'un éventuel déphasage entre le signal de modulation utilisé pour l'émission et le signal de démodulation utilisé pour la réception.

Cette quantité est image de ΔVᵢₙ, où ΔVᵢₙ est représentatif de la différence des puissances reçues (RH-RB) correspondant à l'émission du bruit blanc de rapport cyclique ½ à la fréquence de modulation Fm.

L'atténuation de blindage est déterminée pour une fréquence donnée F, par le module 123. Elle est égale au rapport de la différence calculée pour la mesure de référence et de la différence calculée pour la seconde mesure : (RH_{ref} - RB_{ref})/(RH - RB). On rappelle que toutes les puissances sont ici exprimées en Watts.

Les traitements effectués à partir du signal reçu par le récepteur 12 peuvent être répétés pour toute fréquence comprise dans la bande de fréquence allant de Fₘᵢₙ à Fₘₐₓ.

La dynamique du système de mesure est augmentée par l'utilisation d'un contrôle automatique de gain de manière à travailler à puissance constante en entrée de la diode de détection.

## Revendications

1. Récepteur (12) pour un système de mesure d'atténuation de blindage électromagnétique d'une infrastructure, en fonction de la fréquence,
**caractérisé en ce qu'**il est apte à recevoir un signal émis par un émetteur (10) d'un signal (SE) qui est un bruit blanc de puissance constante sur une bande de fréquence comprise entre une fréquence minimale et une fréquence maximale, l'émetteur et le récepteur étant aptes à émettre et recevoir un signal de part et d'autre de l'infrastructure,
Et **caractérisé en ce qu'**il comporte
Un module de filtrage (121) apte à réaliser un filtrage glissant sur le signal reçu (SR) entre la fréquence minimale et la fréquence maximale,
Un module de double détection synchrone (122) apte à réaliser une double détection synchrone sur un signal fourni par le module de filtrage, et
Un module (123) de détermination de l'atténuation de blindage en fonction des résultats fournis par le module de double détection synchrone déterminés suite à l'émission et la réception de signal réalisées en l'absence de l'infrastructure puis de part et d'autre de l'infrastructure.

2. Système de mesure d'atténuation de blindage électromagnétique d'une infrastructure, en fonction de la fréquence, **caractérisé en ce qu'**il comporte :
Un émetteur (10) d'un signal (SE) qui est un bruit blanc de puissance constante sur une bande de fréquence comprise entre une fréquence minimale et une fréquence maximale,
Un récepteur (12) de signal (SR) selon la revendication 1.

3. Système de mesure d'atténuation de blindage électromagnétique d'une infrastructure selon la revendication 2, **caractérisé en ce que** :
L'émetteur (10) est apte à émettre un signal (SE) qui est un bruit blanc haché comportant deux niveaux de puissance alternatifs,
Le récepteur (12) est apte à déterminer la différence entre les puissances reçues correspondant aux deux niveaux de puissance du signal émis.

4. Procédé de mesure d'atténuation de blindage électromagnétique d'une infrastructure, en fonction de la fréquence, **caractérisé en ce qu'**il comporte les étapes de :
Emission (E1) d'un signal (SE) qui est un bruit blanc de puissance constante sur une bande de fréquence comprise entre une fréquence minimale et une fréquence maximale,
Réception (E2) d'un signal (SR), l'émission et la réception de signal étant effectuée de part et d'autre de l'infrastructure,
Filtrage glissant (E3) sur le signal reçu (SR) entre la fréquence minimale (Fmin) et la fréquence maximale (Fmax),
Double détection synchrone (E5) sur un signal fourni par l'étape de filtrage glissant, et
**en ce qu'**il comporte des étapes préalables d'émission et de réception de signal en l'absence de l'infrastructure, de filtrage glissant sur le signal reçu et de double détection synchrone sur un signal fourni par l'étape de filtrage glissant, et une étape (E5) de détermination de l'atténuation de blindage en fonction des résultats des étapes de filtrage glissant et de double détection synchrone effectuées suite à l'émission et la réception de signal en l'absence de l'infrastructure puis de part et d'autre de l'infrastructure.

5. Programme d'ordinateur comportant des instructions pour l'exécution des étapes de filtrage glissant et de double détection synchrone du procédé selon la revendication 4 lorsque ledit programme est exécuté par un ordinateur.

6. Support d'enregistrement lisible par un ordinateur sur lequel est enregistré un programme d'ordinateur comprenant des instructions pour l'exécution des étapes de filtrage glissant et de double détection synchrone du procédé selon la revendication 4.

## Patentansprüche

1. Empfänger (12) für ein System zur Messung einer Abschwächung einer elektromagnetischen Abschirmung einer Infrastruktur als Funktion der Frequenz, **dadurch gekennzeichnet, dass** es dazu ausgelegt ist, ein Signal zu empfangen, das durch einen Sender (10) eines Signals (SE) emittiert wird, das ein weißes Rauschen mit konstanter Leistung auf einem Frequenzband ist, das zwischen einer minimalen Frequenz und einer maximalen Frequenz enthalten ist, wobei der Sender und der Empfänger dazu ausgelegt sind, ein Signal auf beiden Seiten der Infrastruktur zu senden und zu empfangen,
und **dadurch gekennzeichnet, dass** er umfasst:
ein Filterungsmodul (121), das dazu ausgelegt ist, eine gleitende Filterung auf dem empfangenen Signal (SR) zwischen der minimalen Frequenz und der maximalen Frequenz zu realisieren,
ein Modul zur Doppelsynchrondetektion (122), das dazu ausgelegt ist, eine Doppelsynchrondetektion auf einem Signal zu realisieren, das durch das Filterungsmodul geliefert wird, und
ein Modul (123) zur Bestimmung der Abschwächung der Abschirmung als Funktion der Resultate, die durch das Modul zur Doppelsynchrondetektion geliefert werden, die im Anschluss an die Aussendung und den Empfang eines Signals bestimmt werden, realisiert in Abwesenheit der Infrastruktur und dann auf beiden Seiten der Infrastruktur.

2. System zur Messung einer Abschwächung einer elektromagnetischen Abschirmung einer Infrastruktur als Funktion der Frequenz, **dadurch gekennzeichnet, dass** es umfasst:
einen Sender (10) eines Signals (SE), das ein weißes Rauschen mit einer konstanten Leistung auf einem Frequenzband ist, das zwischen einer minimalen Frequenz und einer maximalen Frequenz enthalten ist,
einen Empfänger (12) eines Signals (SR) nach Anspruch 1.

3. System zur Messung einer Abschwächung einer elektromagnetischen Abschirmung einer Infrastruktur nach Anspruch 2, **dadurch gekennzeichnet, dass**
der Sender (10) dazu ausgelegt ist, ein Signal (SE) zu senden, das ein zerhacktes weißes Rauschen ist, das zwei alternative Leistungsniveaus umfasst,
der Empfänger (12) dazu ausgelegt ist, die Differenz zwischen den empfangenen Leistungen zu bestimmen, die den zwei Leistungsniveaus des gesendeten Signals entsprechen.

4. Verfahren zu Messung einer Abschwächung einer elektromagnetischen Abschirmung einer Infrastruktur als Funktion der Frequenz, **dadurch gekennzeichnet, dass** es die folgenden Schritte umfasst:
Senden (E1) eines Signals (SE), das ein weißes Rauschen mit einer konstanten Leistung auf einem Frequenzband ist, das zwischen einer minimalen Frequenz und einer maximalen Frequenz enthalten ist,
Empfangen (E2) eines Signals (SR), wobei das Senden und das Empfangen des Signals auf beiden Seiten der Infrastruktur durchgeführt werden,
gleitendes Filtern (E3) auf dem empfangenen Signal (SR) zwischen der minimalen Frequenz (Fmin) und der maximalen Frequenz (Fmax),
Doppelsynchrondetektion (E5) auf einem Signal, das durch den Schritt der gleitenden Filterrung bereitgestellt wird, und
dass es die vorhergehenden Schritte des Sendens und des Empfangens eines Signals in Abwesenheit der Infrastruktur, der gleitenden Filterung auf dem empfangenen Signal und der Doppelsynchrondetektion auf einem Signal umfasst, das durch den Schritt der gleitenden Filterrung bereitgestellt wird, sowie einen Schritt (E5) der Bestimmung der Abschwächung der Abschirmung als Funktion der Resultate der Schritte der gleitenden Filterung und der Doppelsynchrondetektion, durchgeführt im Anschluss an das Senden und den Empfang des Signals in Abwesenheit der Infrastruktur und dann auf beiden Seiten der Infrastruktur.

5. Computerprogramm, umfassend Instruktionen zum Ausführen der Schritte der gleitenden Filterung und der Doppelsynchrondetektion des Verfahrens nach Anspruch 4, wenn das Programm durch einen Computer ausgeführt wird.

6. Datenträger, der durch einen Computer auslesbar ist, auf dem ein Computerprogramm aufgezeichnet ist, umfassend Instruktionen zur Durchführung der Schritte der gleitenden Filterung und der Doppelsynchrondetektion des Verfahrens nach Anspruch 4.

## Claims

1. Receiver (12) for a system for measurement of the attenuation of electromagnetic shielding of an infrastructure as a function of the frequency,
characterised it that it is capable of receiving a signal transmitted by a transmitter (10) of a white noise signal (SE) with constant power over a frequency band between a minimum frequency and a maximum frequency, the transmitter and the receiver being capable of transmitting and receiving a signal on opposite sides of the infrastructure,
And **characterised in that** it comprises
A filter module (21) capable of applying a sliding filter on the received signal (SR) between the minimum frequency and the maximum frequency,
A double synchronous detection module (122) capable of double synchronous detection on a signal output by the filter module, and
A module (123) for determination of the shielding attenuation as a function of the results output by the double synchronous detection module determined following signal transmission and reception in the absence of the infrastructure and then on each side of the infrastructure.

2. System for measuring the attenuation of electromagnetic shielding of an infrastructure as a function of the frequency, **characterised in that** it comprises:
A transmitter (10) of a white noise signal (SE) with a constant power over a frequency band between a minimum frequency and a maximum frequency,
A receiver (12) of a signal (SR) according to claim 1.

3. System for measuring the attenuation of electromagnetic shielding of an infrastructure according to claim 2, **characterised in that**:
The transmitter (10) is capable of transmitting a signal (SE) that is chopped white noise comprising two alternating power levels,
The receiver (12) is capable of determining the difference between received powers corresponding to two power levels of the transmitted signal.

4. Method for measuring the attenuation of electromagnetic shielding of an infrastructure as a function of the frequency, **characterised in that** it comprises the following steps:
Transmission (E1) of a white noise signal (SE) with a constant power over a frequency band between a minimum frequency and a maximum frequency,
Reception (E2) of a signal (SR), the signal transmission and reception taking place on opposite sides of the infrastructure,
Sliding filter (E3) on the received signal (SR) between the minimum frequency (Fmin) and the maximum frequency (Fmax),
Double synchronous detection (E5) on a signal output by the sliding filter step, and
**in that** it comprises preliminary steps of transmission and reception of a signal in the absence of the infrastructure, application of the sliding filter on the received signal and double synchronous detection on a signal output by the sliding filter step, and a step (E5) of determination of the shielding attenuation as a function of the results of the sliding filter and double synchronous detection steps performed following signal transmission and reception in the absence of the infrastructure and then on each side of the infrastructure.

5. Computer program containing instructions for execution of the sliding filter and double synchronous detection steps in the method according to claim 4 when said program is executed by a computer.

6. Storage medium that can be read by a computer, in which a computer program is stored containing instructions for execution of the sliding filter and double synchronous detection steps in the method according to claim 4.
